# EUROPÄISCHE PATENTANMELDUNG

(11) **EP 1 840 420 A1**
(43) Veröffentlichungstag der Anmeldung: **03.10.2007**
(21) Anmeldenummer: 06006675.0
(22) Anmeldetag: 30.03.2006
(51) Int. Cl.: F16J 15/06, H05K 5/06

(54) **Platte mit Flachdichtung**

(71) Anmelder: Siemens Aktiengesellschaft, 80333 Munich (DE)
(72) Erfinder: Fremuth, Erwin, 90613 Grosshabersdorf (DE); Papenberg, Gerhard, 90766 Fürth (DE)

(57) **Zusammenfassung**

Die Erfindung betrifft eine Platte (1) zum Auf- und/oder Einsetzen auf eine Vorrichtung (4), wobei ein Gehäusedeckel (3) zum Einbau der Platte (4) vorgesehen und durch sie zumindest teilweise abdeckbar ist. Eine Flachdichtung (2) wird zur Abdichtung der Vorrichtung (4) zwischen der Platte (1) und dem Gehäusedeckel (3) angeordnet. Die Platte (1) weist einen Vorsprung (5) umlaufend an ihrem Rand auf, wobei der Vorsprung (5) zur Ausübung eines Drucks auf die Flachdichtung (2) bei Befestigung der Platte (1) auf dem Gehäusedeckel (3) vorgesehen ist. Da die Vorrichtung (4) bereits bei geringem Anpressdruck auf die Platte (1) zuverlässig, zuerst an der Außenkante der Platte (1) abgedichtet wird, können die Materialdicke des Gehäusedeckels (3) und der Platte (1) geringer hergestellt werden, dadurch können die Herstellungskosten der Vorrichtung (4) erheblich reduziert werden.

## Beschreibung

Die Erfindung betrifft eine Platte zum Auf- und/oder Einsetzen auf eine Vorrichtung, welche einen plattenförmigen Gehäusedeckel umfasst, der durch die Platte zumindest teilweise abdeckbar ist, wobei eine Flachdichtung zur Abdichtung zwischen der Platte und dem Gehäusedeckel anordenbar ist.

Beim frontseitigen Einbau von Komponenten oder Frontplatten im einen Gehäusedeckel einer Vorrichtung/eines Geräts ist eine Erzielung einer gleichmäßigen und hohen Dichtigkeit wünschenswert, weil oft Reinigungsmittel (Wasser, Säuren oder Laugen) mit hohem Druck aufgebracht werden, oder die Vorrichtung aus welchen Gründen auch immer in nasser Umgebung oder im Freien betrieben werden muss. Insbesondere wird in der Nahrungs- und Genussmittelindustrie (NuG-Industrie) ein zunehmender Wert auf die Beachtung von Hygienevorschriften gelegt.

Viele Geräte werden wegen der damit verbundenen Schutzart (z.B. IP66k oder IP66, international Protection 66) beispielsweise für einen Einbau in Fronttafeln oder in Steuerpulte mit Flachdichtungen vorgesehen. Dabei werden Dichtungen möglichst breit dimensioniert, um einen höheren Dichtgrad zu erreichen. Nachteilig ist jedoch, dass durch die große Dichtungsbreite erstens der zur Erzielung der Dichtwirkung erforderliche Anpressdruck zu groß ist, was leicht zum Verzug einer einzubauenden Frontplatte bzw. eines Gehäuses führen kann. Es ist bei Touchpanels/Touchscreens besonders problematisch, weil Fehlfunktionen auftreten können. Zweitens steigt der Platzbedarf und die Dicke der einzubauenden Frontplatte bzw. des Gehäuses, was sich negativ auf die Herstellungskosten der Geräte auswirken kann. Außerdem besteht die Gefahr, dass, bedingt durch eine ungleichmäßige Dichtwirkung, Schmutz und Flüssigkeiten durch die Kapillarwirkung eines feinen Spalts zwischen der Frontplatte und der Flachdichtung bzw. dem Gehäuse und der Flachdichtung eindringen können bzw. selbst bei Reinigungsvorgängen mit Reinigungsmitteln oder Hochdruckreinigern nicht mehr zu entfernen sind. Deswegen kann das erforderliche wirkungsvolle Dichtungskonzept durch eine breit dimensionierte Dichtfläche nicht gewährleistet werden.

Der Erfindung liegt die Aufgabe zugrunde, eine zuverlässige Abdichtung einer Vorrichtung, welche einen plattenförmigen Gehäusedeckel umfasst, zu ermöglichen.

Diese Aufgabe wird erfindungsgemäß durch eine Platte mit den Merkmalen des Patentanspruchs 1 gelöst. Die abhängigen Ansprüche betreffen vorteilhafte Weiterbildungen und Ausgestaltungen der Erfindung.

Der Erfindung liegt die Idee zugrunde, durch einen Vorsprung einen größeren Anpressdruck auf dem Rand einer Flachdichtung auszuüben. Erfindungsgemäß wird eine Platte zum Auf- und/oder Einsetzen auf eine Vorrichtung, welche einen plattenförmigen Gehäusedeckel umfasst, vorgesehen. Der Gehäusedeckel kann durch die Platte zumindest teilweise abgedeckt werden, und eine Flachdichtung wird zur Abdichtung dieser Vorrichtung zwischen der Platte und dem Gehäusedeckel angeordnet. Die Platte weist einen Vorsprung (Nase) umlaufend an ihrem Rand auf, wobei dieser Vorsprung zur Ausübung eines Drucks auf die Flachdichtung bei Befestigung der Platte auf dem Gehäusedeckel vorgesehen wird. Dementsprechend erfolgt eine Abdichtung durch die auf die Flachdichtung bzw. Platte wirkende Anpressung. Da die Flachdichtung sich in Bezug auf den Gehäusedeckel neigt, wird die Vorrichtung somit durch einen Druck auf die Platte in dem Gehäusedeckel bereits bei geringem Anpressdruck zuverlässig zuerst an der Außenkante der Platte abgedichtet. Die Materialdicke des Gehäusedeckels oder der Platte kann dadurch auch bei Einbau von größeren und schwereren Komponenten gering gehalten werden (z.B. bis zu 1,5 mm), während es bei einer herkömmlichen Dichtung wenigstens 3 mm sind. Die Breite der Flachdichtung wird dadurch erheblich reduziert und der Platzbedarf für die Flachdichtung und damit die Herstellungskosten der gesamten Vorrichtung werden damit erheblich reduziert.

Gemäß einer vorteilhaften Ausgestaltung der Erfindung wird die Platte als ein plattenförmiger Rahmen ausgestaltet, wobei umlaufend an ihrem äußeren Rand ein Vorsprung vorgesehen ist. Dadurch können die im Gehäusedeckel eingebauten Bauelemente mit anderen Elementen von Außen verbunden werden, oder es kann mittels des Rahmens ein anderes Gerät auf der Vorrichtung eingebaut werden.

In der Regel besteht die Flachdichtung beispielsweise aus einem verformbaren Material, z.B. Gummi oder Kunststoff. Bei Ausübung von Druck auf die Platte wird das Material der Flachdichtung seitlich verdrängt. An der Stelle, wo der Vorsprung auf die Flachdichtung aufliegt, weist die Flachdichtung seitlich eine Krümmung nach außen bündig auf. Somit kann das Vertrauen des Kunden auf eine sichere Abdichtung der Vorrichtung gestärkt werden, weil die Flachdichtung von Außen sofort erkennbar ist.

Gemäß einer weiteren vorteilhaften Ausgestaltung der Erfindung wird der Vorsprung mit einer Höhe, die geringer als die Dicke der Flachdichtung ist, gefertigt. Wird die Flachdichtung mit der Platte auf den Gehäusedeckel gelegt, kann dadurch eine gleichmäßige und zuverlässige Abdichtung erreicht werden. D.h. eine Abdichtung der Vorrichtung wird nicht nur am Vorsprung, sondern auch überall unter der gesamten Platte zuverlässig gewährleistet.

Häufig wird eine Anzeige oder ein Funktionspanel bei einer Vorrichtung verwendet, wobei eine Fronttafel oder Steuerpulte zur Halterung der Anzeige oder des Funktionspanels gebraucht wird. Zu diesem Zweck kann eine derartige Platte auch zur Befestigung bzw. Halterung der Anzeige oder des Funktionspanels verwendet werden.

Zum besseren Einbau von Komponenten der Vorrichtung (z.B. Anzeige, Funktionspanel usw.) wird die Platte und/oder der Gehäusedeckel aus Metall ausgestaltet.

Nachfolgend wird die Erfindung anhand der in den Figuren dargestellten Ausführungsbeispiele näher beschrieben und erläutert. Es zeigen:
- FIG 1: eine Seitenansicht einer herkömmliche Platte zur Abdichtung,
- FIG 2: Existenz eines Spaltes bei einer herkömmliche Platte zur Abdichtung,
- FIG 3: eine Seitenansicht einer erfindungsgemäßen Platte zur Abdichtung, und
- FIG 4: Abdichtung durch eine erfindungsgemäßen Platte.

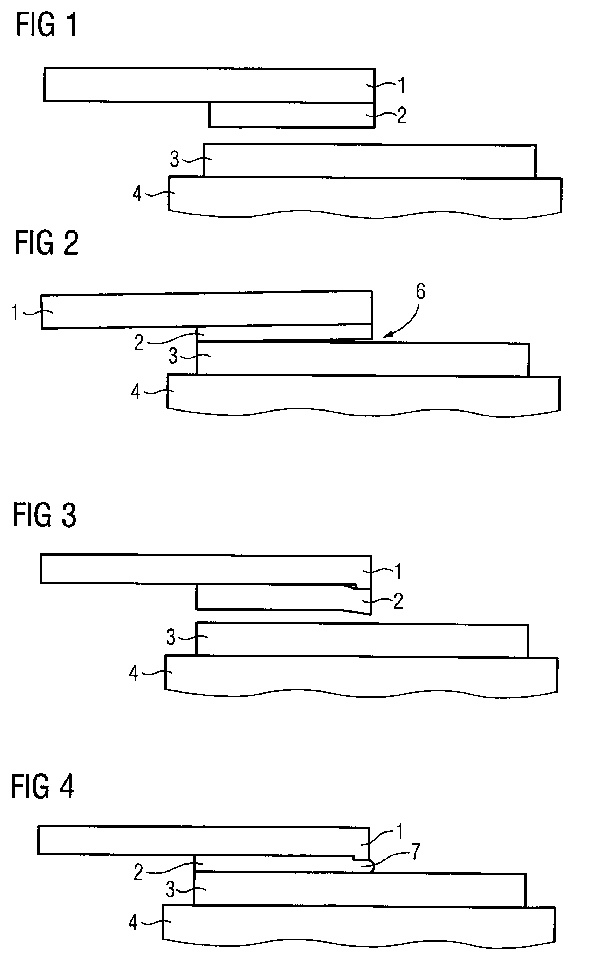

Gemäß FIG 1 wird eine herkömmliche Platte 1 zur Abdichtung einer Vorrichtung 4, welche einen plattenförmigen Gehäusedeckel 3 oder eine Tür aufweist, dargestellt. Der Gehäusedeckel 3 wird durch die Platte 1 zum Teil abgedeckt. Da sich im Gehäuse der Vorrichtung 4 mehrere elektronische Bauelemente befinden, wird eine Flachdichtung 2 zur Abdichtung der Vorrichtung 4 zwischen der Platte 1 und dem Gehäusedeckel 3 angeordnet und mit dieser Platte 1 zusammen auf den Gehäusedeckel 3 aufgelegt. Beispielsweise können eine solche Platte 1 aus einem entsprechend geeigneten Metall hergestellt werden und die Flachdichtung 2 aus Gummi bestehen. Der Anpressdruck muss auf der Platte 1 relativ groß sein, um eine bessere Dichtwirkung zu erreichen. Das kann aber leicht zum Verzug der Platte 1 bzw. des Gehäusedeckels 3 führen. Zudem besteht die Gefahr, dass ein Spalt 6 zwischen der Flachdichtung 2 und dem Gehäusedeckel entstehen kann, denn üblicherweise verformen sich die Flachdichtung 2 und eventuell auch der Gehäusedeckel 3 nach längerer Zeit. Ein solcher Spalt 6 ist in FIG 2 dargestellt. Die Dichtung liegt umlaufend daher nicht mehr gleichmäßig auf. Wegen einer ungleichmäßigen Dichtwirkung können Schmutz und Flüssigkeiten durch den feinen Spalt eindringen und bei Reinigungsvorgängen mit Reinigungsmitteln oder Hochdruckreinigern nicht mehr entfernt werden.

In FIG 3 wird eine Platte 1 zur Abdichtung einer Vorrichtung 4 gezeigt. Die Platte 1 ist mit einer Flachdichtung 2 zur Abdichtung der oben erwähnten Vorrichtung 4 verwendet, wobei die Platte 1 auf die Vorrichtung 4 auf- bzw. eingesetzt wird und den Gehäusedeckel 3 teilweise abdeckt. Zur besseren Abdichtung weist die Platte 1 umlaufend einen Vorsprung 5 an ihrem Rand auf. Zur Ausstattung des Vorsprungs 5 wird die Platte 1 auf ihrer Rückseite umlaufend in gleichmäßigem Abstand (z.B. 2 mm) von ihrem Rand geringfügig eingefräst. Wird die Flachdichtung 2 vorab auf der Platte 1 gelegt, wird sie zuerst außen am Vorsprung 5 aufgelegt und anschließend komplett in der Einfräsung der Platte 1 hingelegt.

In FIG 4 wird dargestellt, dass eine Abdichtung für die Vorrichtung 4 durch diese Platte 1 mit der Flachdichtung 2 realisiert wird. Mit dem Vorsprung 5 kann ein Druck auf die Flachdichtung 2 bei Befestigung der Platte 1 auf dem Gehäusedeckel 3 ausgeübt werden. An der Stelle, wo der Druck ausgeübt wird, wird das Material der Flachdichtung 2 seitlich verdrängt und eine bündige Krümmung 7 seitlich nach außen erzeugt. Damit können Kunden von außen die Flachdichtung sofort erkennen und folglich auf die Abdichtung der Vorrichtung vertrauen.

Die Höhe des Vorsprungs 5 ist in der Regel geringer als die Dicke der Flachdichtung 2. Dadurch kann die Flachdichtung 2 mittels der Platte 1 gleichmäßig und fest auf dem Gehäusedeckel 3 gelegt werden, um eine zuverlässige Abdichtung zu ermöglichen.

Durch eine derartige Platte 1 ist das Erreichen hoher Schutzarten (z.B. IP66, IP66K) und eines den Anforderungen des Hygienic-Design entsprechenden Dichtkonzepts problemlos möglich, weil keine Spalten zwischen der Flachdichtung 2 und der Platte 1 oder dem Gehäusedeckel 3 entstehen. Dadurch kann die Dichtigkeit der Vorrichtung 4 gegen die Umgebung (Flüssigkeiten, Schmutz und Keime usw.) gewährleistet werden. Die Platte (1) kann als ein plattenförmiger Frontrahmen für den Einbau von Panels im HMI-Umfeld (HMI: Human-Maschine-Interface) ausgestaltet und insbesondere in der Nahrungs- und Genussmittelindustrie (NuG-Industrie) verwendet. Dabei können die Panels Bediengeräte bis hin zu Monitoren mit Touchfunktion sein.

## Patentansprüche

1. Platte (1) zum Auf- und/oder Einsetzen auf eine Vorrichtung (4), welche einen plattenförmigen Gehäusedeckel (3) umfasst, wobei der Gehäusedeckel (3) durch diese Platte (1) zumindest teilweise abdeckbar ist, wobei eine Flachdichtung (2) zur Abdichtung zwischen der Platte (1) und dem Gehäusedeckel (3) anordenbar ist, wobei die Platte (1) umlaufend einen Vorsprung (5) an ihrem Rand aufweist, und wobei der Vorsprung (5) zur Ausübung eines Drucks auf die Flachdichtung (2) bei der Befestigung der Platte (1) auf dem Gehäusedeckel (3) vorgesehen ist.

2. Platte (1) nach Anspruch 1, **dadurch gekennzeichnet, dass** die Platte (1) ein plattenförmiger Rahmen ist, wobei umlaufend an ihrem äußeren Rand ein Vorsprung (5) vorgesehen ist.

3. Platte (1) nach Anspruch 1 oder 2, **dadurch gekennzeichnet, dass** bei Ausübung von Druck auf die Platte (1) das Material der Flachdichtung (2) seitlich verdrängbar ist.

4. Platte (1) nach Anspruch 1 oder 2, **dadurch gekennzeichnet, dass** die Höhe des Vorsprungs (5) geringer ist als die Dicke der Flachdichtung (2).

5. Platte (1) nach einem der vorherigen Ansprüche, **dadurch gekennzeichnet , dass** die Platte (1) zur Befestigung einer Anzeige oder eines Funktionspanels der Vorrichtung (4) vorgesehen ist.

6. Platte (1) nach einem der vorherigen Ansprüche, **dadurch gekennzeichnet , dass** die Platte (1) und/oder der Gehäusedeckel (3) aus Metall ausgestaltet sind.
